# DEMANDE DE BREVET EUROPEEN

(11) **EP 4 775 709 A2**
(43) Date de publication de la demande: **15.07.2026**
(21) Numéro de dépôt: 26150963.2
(22) Date de dépôt: 09.01.2026
(51) Int. Cl.: C23C 14/00, C23C 14/02, C23C 14/20, B05D 5/06, B32B 15/20, B05D 7/00, C03C 17/36, C23C 28/00, B44F 1/08, C23C 14/04

(54) **PIECE DE FINITION PRESENTANT UN REVETEMENT DECORATIF METALLIQUE SEMI-TRANSPARENT**

(30) Priorité: 10.01.2025 FR 2500244
(71) Demandeur: Plastiques du Val de Loire, 37130 Langeais (FR)
(72) Inventeur: Compoint, François, 37130 Langeais (FR)
(74) Mandataire: Santarelli

(57) **Abrégé**

L'invention concerne une pièce de finition (10), comprenant un substrat (11) transparent ou semi-transparent en matière plastique et un revêtement décoratif (12) semi-transparent appliqué sur tout ou partie du substrat (11), le revêtement décoratif (12) semi-transparent comprenant une couche métallique réfléchissante (14) semi-transparente composée de chrome, de cuivre ou d'aluminium, ainsi qu'une couche interférentielle (15) transparente ou semi-transparente composée de silicium élémentaire, superposée sur la couche métallique réfléchissante (14), chacune de la couche métallique réfléchissante (14) et la couche interférentielle (15) présentant une épaisseur prédéterminée pour conférer ensemble à la pièce de finition (10) une couleur interférentielle en réflexion prédéterminée ainsi qu'une transmission lumineuse prédéterminée.

## Description

### DOMAINE TECHNIQUE DE L'INVENTION

Le domaine de l'invention est celui des pièces de finition (également appelées « trim part » en terminologie anglaise) pour la finition de dispositifs variés.

Plus précisément, l'invention concerne une pièce de finition présentant un revêtement décoratif métallique semi-transparent, et un dispositif comprenant une telle pièce.

L'invention concerne également un procédé de fabrication d'une telle pièce.

L'invention trouve notamment des applications dans le domaine des pièces de finition intérieures ou extérieures de véhicules, de préférence automobiles, des pièces de finition d'appareils électroménagers, ou des contenants, de préférence cosmétiques ou alimentaires.

### ÉTAT DE LA TECHNIQUE

Il est connu de l'art antérieur des techniques permettant de produire des pièces en matériau plastique ayant diverses caractéristiques visuelles et fonctionnelles adaptées à des applications variées.

Par exemple, on connaît des pièces plastiques métallisées, obtenues par exemple par l'application de revêtements métalliques, conférant à ces pièces un aspect métallique ou réfléchissant.

On connaît également des pièces plastiques transparentes, réalisées à partir de polymères optiquement transparents.

On connaît par ailleurs des pièces plastiques comportant à la fois des zones opaques et des zones transparentes ou translucides, obtenues par exemple par le masquage sélectif ou l'ajout de couches fonctionnelles, ces pièces répondant à des besoins spécifiques, notamment dans les domaines de l'éclairage, de la décoration ou des interfaces utilisateurs.

Il existe toutefois un besoin de pièces de finition en matière plastique qui présentent à la fois une transmissivité lumineuse et un aspect métallique qui soit en outre également coloré.

### EXPOSÉ DE L'INVENTION

La présente invention vise à fournir une pièce de finition qui présente un revêtement décoratif d'aspect métallique amélioré par rapport à la technique connue, et qui présente à la fois une semi-transparence ainsi qu'un aspect coloré.

L'invention a ainsi pour objet, selon un premier aspect, une pièce de finition comprenant un substrat transparent ou semi-transparent en matière plastique et un revêtement décoratif semi-transparent appliqué sur tout ou partie du substrat, le revêtement décoratif semi-transparent comprenant une couche métallique réfléchissante semi-transparente composée de chrome, de cuivre ou d'aluminium, ainsi qu'une couche interférentielle transparente ou semi-transparente composée de silicium élémentaire, superposée sur la couche métallique réfléchissante.

Chacune de la couche métallique réfléchissante et la couche interférentielle présente une épaisseur prédéterminée

Ces épaisseurs prédéterminées conférent ensemble à la pièce de finition une couleur interférentielle en réflexion prédéterminée ainsi qu'une transmission lumineuse prédéterminée.

On note que la couleur interférentielle en réflexion prédéterminée ainsi que la transmission lumineuse prédéterminée sont obtenues directement par le choix des épaisseurs de la couche métallique réfléchissante et de la couche interférentielle. Autrement dit, la couleur et la transmission lumineuse obtenues découlent directement des épaisseurs qui sont choisies librement selon les besoins.

Dans la présente description, le terme « transparence » ou « transparent » désigne une transmittance ou transmission lumineuse de la lumière visible d'au moins 90 %, de préférence d'au moins 95 %, en particulier de 100 %. En règle générale, la lumière visible est présente dans la gamme de longueurs d'onde comprise entre 380 nm et 780 nm. Le terme « opacité » ou « opaque » désigne une transmittance ou transmission lumineuse de la lumière visible inférieure à 5 %, en particulier 0 %. Le terme « semi-transparent » ou « semi-transparence » désigne une transmittance transmission lumineuse de la lumière visible inférieure à 90 % et supérieure ou égale à 5 %. Les pourcentages se réfèrent à l'intensité de la lumière, mesurée dans chaque cas sur un côté de la structure bidimensionnelle (par exemple, une portion plane du substrat) à examiner, par rapport à l'intensité de la lumière incidente sur l'autre côté de la structure bidimensionnelle. Pour une telle mesure, par exemple, une source de lumière blanche (source de lumière visible centrée autour d'une longueur d'onde centrale autour d'environ 550 à 600 nm pour la lumière blanche) peut être placée d'un côté de la structure plane et un détecteur de lumière visible de l'autre côté de la structure plane.

La couche interférentielle composée de silicium élémentaire, associée à la couche métallique réfléchissante, permet de générer un aspect coloré de la pièce de finition par des effets optiques d'interférence à l'interface de la couche métallique réfléchissante et de la couche interférentielle.

En particulier, la couche interférentielle peut être constituée de silicium élémentaire, ou constituée essentiellement de silicium élémentaire, à des impuretés près.

La couche interférentielle est une couche de silicium élémentaire, ou silicium « pur », noté Si.

Autrement dit, le silicium élémentaire est du silicium élémentaire au degré d'oxydation 0 (noté Si(0)).

Ce silicium élémentaire peut être un silicium amorphe, noté a-Si, pouvant notamment être un silicium amorphe hydrogéné, noté a-Si:H ; un silicium polycristallin ; un silicium monocristallin, noté c-Si ; ou encore un silicium nanocristallin, noté nc-Si.

En particulier, sont exclus de la couche interférentielle tous les composés du silicium, dont notamment l'oxyde de silicium, le nitrure de silicium, l'oxynitrure de silicium, le carbure de silicium, et tous alliages de silicium avec d'autres éléments

Selon l'épaisseur de la couche interférentielle, des interférences constructives d'une part, et destructives d'autres part, apparaissent pour différentes longueurs d'onde de la lumière incidente en direction de la couche interférentielle et qui est réfléchie sur la couche métallique réfléchissante.

Ainsi, les longueurs d'onde faisant l'objet d'une interférence constructive et qui sont réfléchies, générant un aspect coloré lorsque la pièce de finition est exposée à la lumière, peuvent être contrôlées au moyen du contrôle de l'épaisseur de la couche interférentielle.

La transmission lumineuse, c'est-à-dire la proportion de lumière transmise à travers le revêtement décoratif, est déterminée par l'épaisseur à la fois de la couche métallique réfléchissante et de la couche interférentielle.

En d'autres termes, par le choix d'une épaisseur prédéterminée pour chacune de la couche métallique réfléchissante et de la couche interférentielle, à la fois la transmission lumineuse de la pièce de finition et la couleur interférentielle apparente de la pièce de finition peuvent être prédéterminés.

Le choix d'une couche métallique réfléchissante parmi une couche de chrome, une couche de cuivre et une couche d'aluminium permet d'obtenir un aspect visuel métallique et de générer l'interférence avec la couche interférentielle, tout en procurant une semi-transparence (ou semi-opacité) avec une épaisseur de couche particulièrement faible.

En particulier, la couche métallique peut être constituée de chrome, de cuivre ou d'aluminium, ou constituée essentiellement de chrome, de cuivre ou d'aluminium, à des impuretés près.

De plus, la transmission lumineuse souhaitée peut être contrôlée finement, par des faibles ajustements de l'épaisseur de la couche métallique réfléchissante.

Le choix d'une couche interférentielle composée de silicium permet d'obtenir à la fois une forte transparence ou semi-transparence et une large palette de couleurs interférentielles, par des faibles ajustements de l'épaisseur de la couche interférentielle.

Il en résulte une pièce de finition comportant un revêtement décoratif qui présente un aspect à la fois métallique et coloré, tout en présentant une semi-transparence.

Par ailleurs, ce revêtement décoratif est particulièrement tolérant à l'ajout de couches de protection et/ou de base transparentes ou semi-transparentes, le choix de la composition de la couche métallique réfléchissante et de la couche interférentielle ayant pour effet que les effets interférentiels colorés restent sensiblement inchangés malgré l'ajout de telles couches de protection et/ou de base.

De plus, un tel revêtement, dont les couches constitutives sont composées respectivement d'une part de chrome, de cuivre ou d'aluminium, et d'autre part de silicium, peut être fabriqué de manière particulièrement simple et commode, par exemple au moyen d'un dépôt physique en phase vapeur, notamment sans nécessiter quelconque gaz réactif.

En outre, le revêtement décoratif ainsi obtenu est particulièrement économique, peu sujet à la corrosion, et présente une empreinte carbone faible et une faible toxicité pour les écosystèmes.

D'autres caractéristiques avantageuses de la pièce de finition sont décrites ci-après.

Selon un mode de réalisation préférentiel, la couche métallique réfléchissante semi-transparente est composée de chrome.

Une couche métallique composée de chrome, associée à une couche interférentielle composée de silicium forme un système interférentiel générant des couleurs particulièrement marquées tout en procurant une forte semi-transparence du système.

Selon un mode de réalisation préférentiel, la couche métallique réfléchissante et la couche interférentielle peuvent présenter une épaisseur prédéterminée pour conférer à la pièce une transmission lumineuse pour les longueurs d'ondes d'environ 600 nanomètres qui peut être inférieure ou égale à 60 %, et préférentiellement supérieure ou égale à 5 %.

Une telle valeur de transmission lumineuse permet de procurer à la pièce de finition à la fois un aspect métallique coloré et un aspect semi-transparent permettant une visibilité à travers la pièce.

Selon un mode de réalisation préférentiel, la couche métallique réfléchissante peut présenter une épaisseur comprise entre 10 et 40 nanomètres, préférentiellement entre 15 et 35 nanomètres, et encore plus préférentiellement de l'ordre de 25 nanomètres.

De telles épaisseurs permettent d'obtenir un compromis idéal entre la réflexion lumineuse générée par la couche métallique réfléchissante, et une transmission lumineuse suffisamment élevée pour obtenir une semi-transparence du revêtement décoratif.

Selon un mode de réalisation préférentiel, la couche interférentielle peut présenter une épaisseur comprise entre 20 et 100 nanomètres.

De telles épaisseurs permettent de contrôler la couleur interférentielle générée par la couche interférentielle sur une large palette de teintes de couleur, tout en assurant une transmission lumineuse suffisamment élevée pour obtenir une semi-transparence du revêtement décoratif.

Selon un mode de réalisation préférentiel, la couche métallique réfléchissante peut être déposée sur le substrat, et la couche interférentielle peut être déposée sur la couche métallique

Il en résulte une pièce de finition présentant un décor dit « en première surface », c'est-à-dire sur une surface destinée à faire face à un utilisateur de la pièce.

Selon une variante, la couche interférentielle peut être déposée sur le substrat, et la couche métallique réfléchissante peut être déposée sur la couche interférentielle.

Il en résulte une pièce de finition présentant un décor dit « en deuxième surface », c'est-à-dire sur une surface destinée à être opposée à un utilisateur de la pièce, le décor étant visible à travers le substrat transparent ou semi-transparent.

Selon un mode de réalisation préférentiel, la pièce de finition peut comprendre en outre une couche de protection transparente ou semi-transparente, déposée sur le revêtement décoratif.

Une telle couche permet avantageusement de protéger le revêtement décoratif d'agressions extérieures.

Le système comprenant le revêtement décoratif et la couche de protection forme un système optique « lentillaire », pouvant en principe conduire à des effets optiques importants, notamment des effets interférentiels. La composition du revêtement décoratif tel que défini ci-avant permet néanmoins de conserver des effets optiques générés par le revêtement décoratif, et en particulier des effets colorés interférentiels, sensiblement inchangés malgré la présence de la couche de protection.

La couche de protection transparente ou semi-transparente peut être déposée sur un revêtement décoratif déposé en première surface ou bien déposé en deuxième surface.

La pièce de finition peut également comprendre une couche de protection additionnelle transparente ou semi-transparente, déposée directement sur le substrat sur une face opposée à une face sur laquelle est déposé le revêtement décoratif, en particulier lorsque le revêtement décoratif est déposé en deuxième surface.

De préférence, la couche de protection et/ou la couche de protection additionnelle présentent une transmission lumineuse supérieure à 90% pour les longueurs d'onde autour de 600 nm, et sont de préférence dépourvues de tout agent colorant.

Selon un mode de réalisation, en particulier lorsque le revêtement décoratif est déposé en deuxième surface, la couche de protection transparente ou semi-transparente déposée sur le revêtement décoratif peut être pelable, et peut être transparente ou semi-transparente ou bien être opaque.

Selon un mode de réalisation préférentiel, la couche de protection peut être un vernis comprenant une base choisie parmi le polyuréthane, l'époxy ou l'acrylate, et configurée pour être réticulée par un procédé thermique, par rayonnement ultraviolet (UV) ou par une combinaison des procédés précités, le vernis pouvant comprendre un agent matant.

Une telle composition de la couche de protection permet avantageusement de réduire davantage encore les effets optiques indésirables, susceptibles de modifier ou d'éteindre des effets interférentiels colorés générés par le revêtement décoratif.

Selon un mode de réalisation préférentiel, la couche de protection peut présenter une épaisseur comprise entre 10 et 30 micromètres, et préférentiellement entre 15 et 20 micromètres.

Une telle épaisseur permet de protéger efficacement le revêtement décoratif des agressions extérieures lors de la manipulation de la pièce et/ou lors de son utilisation.

Selon un mode de réalisation préférentiel, la couche interférentielle peut comprendre au moins une portion présentant un gradient d'épaisseur entre une zone de la couche interférentielle présentant ladite épaisseur prédéterminée et une zone dépourvue de couche interférentielle et possiblement de couche réfléchissante, ladite au moins une portion pouvant conférer localement à la pièce de finition un dégradé de couleurs interférentielles en réflexion.

La portion présentant un gradient d'épaisseur de la couche interférentielle permet de générer un dégradé interférentiel de couleurs, en raison des différentes interférences optiques générées sur l'étendue de la portion présentant le gradient d'épaisseur.

On entend ici par un gradient d'épaisseur une zone où l'épaisseur de la couche décroit, de préférence strictement, entre la zone de la couche interférentielle présentant ladite épaisseur prédéterminée et la zone dépourvue de couche interférentielle.

La couche métallique réfléchissante peut également comprendre au moins une portion présentant un gradient d'épaisseur entre une zone de la couche métallique réfléchissante présentant ladite épaisseur prédéterminée et une zone dépourvue de couche métallique réfléchissante.

La transmission lumineuse du revêtement décoratif hors des zones d'épaisseur prédéterminé de la couche interférentielle et/ou de la couche métallique réfléchissante peut être sensiblement supérieure à la transmission lumineuse au niveau de des zones d'épaisseur prédéterminé de la couche interférentielle et/ou de la couche métallique réfléchissante, et peut par exemple être de l'ordre de 50 à 90 % pour les longueurs d'ondes d'environ 600 nanomètres.

Selon un mode de réalisation préférentiel, le substrat peut être en polycarbonate (PC) ou en polyméthacrylate de méthyle (PMMA), ou en toute autre résine naturellement transparente pouvant être ou non teintée dans la masse, et pouvant être chargé en agents ou par des mélanges maîtres (« master batches » en terminologie anglaise) pouvant conférer des propriétés opalescentes, et/ou nacrantes, et/ou colorantes, et/ou de protection notamment UV et/ou thermique et/ou mécanique.

Selon un mode de réalisation préférentiel, la pièce de finition peut comprendre une couche de base transparente ou semi-transparente, déposée sur le substrat, le revêtement décoratif pouvant être déposé sur la couche de base.

La couche de base transparente ou semi-transparente peut être déposée sur un substrat et le revêtement décoratif peut être déposé en première surface ou bien déposé en deuxième surface.

De préférence, la couche de base présente une transmission lumineuse supérieure à 90% pour les longueurs d'onde autour de 600 nm, et est de préférence dépourvue de tout agent colorant.

De préférence, la couche de base présente une épaisseur comprise entre 10 et 30 micromètres, et préférentiellement entre 15 et 20 micromètres.

Selon un mode de réalisation préférentiel, la couche de base peut être un vernis comprenant une base choisie parmi le polyuréthane, l'époxy ou l'acrylate, et configurée pour être réticulée par un procédé thermique, par rayonnement ultraviolet (UV) ou par une combinaison des procédés précités, le vernis pouvant comprendre un agent matant.

L'invention a également pour objet, selon un deuxième aspect, un dispositif comprenant une pièce de finition telle que décrite ci-avant, le dispositif étant un véhicule, de préférence automobile, un appareil électroménager, ou un contenant, de préférence cosmétique ou alimentaire.

L'invention a également pour objet, selon un troisième aspect, un procédé de fabrication d'une pièce de finition telle que décrite ci-avant, comprenant les étapes de :
- fourniture d'un substrat transparent ou semi-transparent en matière plastique ;
- dépôt de la couche métallique réfléchissante semi-transparente ;
- dépôt de la couche interférentielle semi-transparente.

Selon un mode de réalisation préférentiel, les étapes de dépôt de la couche métallique réfléchissante et/ou de dépôt de la couche interférentielle peuvent être réalisées par dépôt physique en phase vapeur (PVD).

Le dépôt par PVD des couches métallique réfléchissante et/ou interférentielle permet de contrôler finement et précisément les épaisseurs prédéterminées qui sont déposées, et ainsi contrôler précisément les effets optiques et en particulier colorés qui sont obtenus.

De plus, un tel dépôt PVD de couches de chrome, aluminium ou cuivre, et de silicium, peut être réalisé sans nécessiter de gaz réactif, et ne présente pas de risque d'empoisonnement de la cible de matériau à déposer par PVD.

Selon un mode de réalisation préférentiel, l'étape de dépôt de la couche interférentielle semi-transparente peut être réalisée à la suite de l'étape de dépôt de la couche métallique réfléchissante semi-transparente, et le procédé peut comprendre en outre une étape de dépôt d'une couche de protection transparente ou semi-transparente, qui peut être une étape de peinture d'un vernis, réalisée à la suite de l'étape de dépôt de la couche interférentielle semi-transparente.

Ceci permet de réaliser un revêtement décoratif appliqué en première surface, muni d'une couche de protection permettant de protéger le revêtement décoratif des agressions extérieures.

Selon un mode de réalisation préférentiel, l'étape de dépôt de la couche métallique réfléchissante semi-transparente peut être réalisée à la suite de l'étape de dépôt de la couche interférentielle semi-transparente, et le procédé peut comprendre optionnellement une étape de dépôt d'une couche de protection transparente ou semi-transparente, qui peut être une étape de peinture d'un vernis, réalisée à la suite de l'étape de dépôt de la couche métallique réfléchissante semi-transparente.

Ceci permet de réaliser un revêtement décoratif appliqué en deuxième surface, la présence d'une couche de protection optionnelle permettant de protéger le revêtement décoratif en particulier lors de la manipulation de la pièce avant son utilisation, le substrat lui-même protégeant le revêtement décoratif lorsque la pièce est utilisée.

Selon un mode de réalisation préférentiel, le procédé peut comprendre en outre une étape de dépôt d'une couche de base transparente ou semi-transparente sur le substrat, qui peut être une étape de peinture d'un vernis, réalisée avant l'étape de dépôt de la couche interférentielle semi-transparente et l'étape de dépôt de la couche métallique réfléchissante semi-transparente.

Le dépôt d'une couche de base permet de promouvoir l'adhésion du revêtement décoratif sur le substrat, et permet par ailleurs de niveler ou lisser la surface du substrat.

### BRÈVE DESCRIPTION DES FIGURES

D'autres avantages, buts et caractéristiques particulières de la présente invention ressortiront de la description non limitative qui suit d'au moins un mode de réalisation particulier des dispositifs et procédés objets de la présente invention, en regard des dessins annexés, dans lesquels :
- la figure 1 est une représentation schématique en coupe d'une pièce de finition présentant un décor en première surface, au cours d'une première étape de fabrication d'une telle pièce ;
- la figure 2 représente la pièce de la figure 1 suite à une deuxième étape de fabrication ;
- la figure 3 représente la pièce de la figure 2 suite à une troisième étape de fabrication ;
- la figure 4 représente la pièce de la figure 3 suite à une quatrième étape de fabrication ;
- la figure 5 est similaire à la figure 4 et représente une pièce de finition présentant un décor en deuxième surface ;
- la figure 6 est un schéma bloc-diagramme d'un procédé de fabrication d'une pièce de finition ;
- la figure 7 est similaire à la figure 4 et représente une pièce de finition présentant une portion ayant un gradient d'épaisseur du décor.

### DESCRIPTION DÉTAILLÉE DE L'INVENTION

La présente description est donnée à titre non limitatif, chaque caractéristique d'un mode de réalisation pouvant être combinée à toute autre caractéristique de tout autre mode de réalisation de manière avantageuse.

On note, dès à présent, que les figures ne sont pas nécessairement à l'échelle.

L'invention a pour objet une pièce de finition comportant un décor métallique semi-transparent, et qui présente en outre une coloration interférentielle.

La pièce de finition est par exemple une pièce décorative et/ou fonctionnelle destinée à être montée sur un dispositif tel qu'un véhicule, de préférence automobile.

Il peut par exemple s'agir d'une baguette décorative ou encore d'un bouton de commande de tableau de bord.

Selon d'autres applications non limitatives, la pièce de finition est par exemple une pièce décorative et/ou fonctionnelle destinée à être montée sur un appareil électroménager, par exemple un robot de cuisine, un aspirateur, un lave-linge, un sèche-cheveux, ou tout autre appareil.

La pièce de finition peut par exemple également être une pièce décorative et/ou fonctionnelle pour un contenant ou récipient, de préférence cosmétique tel qu'un pot pour crème, ou encore alimentaire.

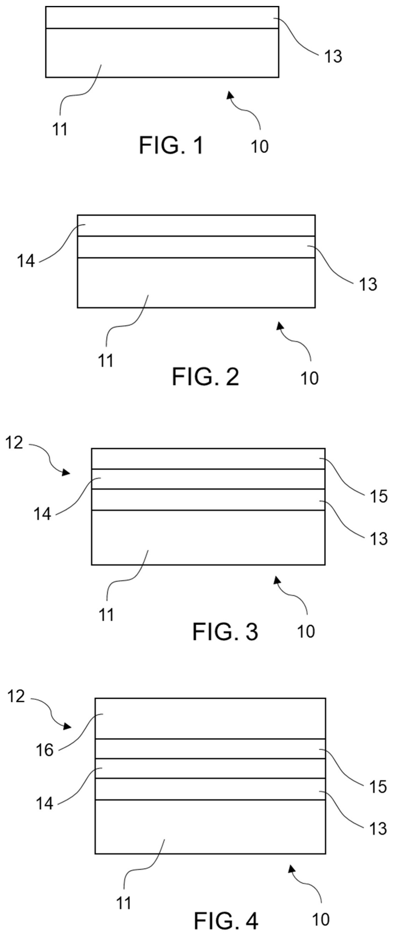

Les figures 1 à 4 illustrent une pièce de finition 10 au cours d'étapes successives de fabrication d'une telle pièce.

La pièce de finition 10 comprend un substrat 11 en matière plastique.

Le substrat 11 est par exemple réalisé en en polycarbonate (PC) ou en polyméthacrylate de méthyle (PMMA), ou en toute autre résine naturellement transparente pouvant être ou non teintée dans la masse, pouvant être chargé en agents ou par des mélanges maîtres (« master batches » en terminologie anglaise) conférant des propriétés opalescentes, et/ou nacrantes, et/ou colorantes ou et/ou de protection notamment UV, et/ou thermique, et/ou mécanique, etc.).

Le substrat 11 peut préalablement avoir été moulé, par exemple par injection, à la forme finale souhaitée pour la pièce de finition 10.

Selon un autre mode de réalisation, le substrat 11 peut par exemple être obtenu par extrusion de matière plastique, par extrusion, par thermoformage, par impression 3D, par emboutissage, ou par usinage.

Le substrat 11 est transparent, ou semi-transparent, c'est-à-dire translucide.

Dans la présente description, le terme « transparent » désigne le fait que la transmission lumineuse (TL) du matériau, c'est-à-dire le pourcentage de lumière visible que le matériau laisse passer, est supérieur à 90% dans les longueurs d'ondes du visible, ou, de façon approximative, supérieure à 90% pour une longueur d'onde centrale autour d'environ 550 à 600 nanomètres (nm) pour la lumière blanche.

Le terme « semi-transparent » ou « translucide » désigne le fait que la transmission lumineuse du matériau est supérieure à 5% dans les longueurs d'ondes du visible, ou, de façon approximative, supérieure à 5% pour une longueur d'onde centrale autour d'environ 550 à 600 nm pour la lumière blanche, et inférieure à 90% dans les longueurs d'ondes du visible, ou, de façon approximative, inférieure à 90% pour une longueur d'onde centrale autour d'environ 550 à 600 nanomètres (nm) pour la lumière blanche.

Un matériau présentant un transmission lumineuse inférieure à 5% est être considéré comme étant « opaque » dans la présente description.

La pièce de finition 10 comprend par ailleurs un revêtement décoratif 12 appliqué sur le substrat 11.

De manière optionnelle, la pièce de finition 10 peut comprendre une couche de base 13 déposée sur le substrat 11.

La couche de base 13 peut présenter des propriétés pour promouvoir l'adhérence du revêtement décoratif 12 sur le substrat 11.

Par exemple, la couche de base 13 peut être un vernis comprenant une base choisie parmi le polyuréthane, l'époxy ou l'acrylate, et configuré pour être réticulée par un procédé thermique, par rayonnement ultraviolet (UV) ou par une combinaison des procédés précités.

Le vernis peut comprendre un agent matant.

La couche de base 13 est transparente ou semi-transparente.

Le revêtement décoratif 12, déposé directement sur le substrat 11 ou sur la couche de base 13 le cas échéant, est semi-transparent.

Le revêtement décoratif 12 comprend une première couche qui est une couche métallique réfléchissante 14, et qui est semi-transparente.

La couche métallique réfléchissante 14 est ici une couche de chrome (Cr), de cuivre (Cu), ou d'aluminium (AI).

De manière préférée, la couche métallique réfléchissante 14 est une couche de chrome.

Le revêtement décoratif 12 comprend une deuxième couche qui est une couche interférentielle 15, et qui est transparente ou semi-transparente.

La couche interférentielle 15 est ici une couche de silicium (Si) élémentaire.

Ce silicium élémentaire peut être un silicium amorphe, noté a-Si, pouvant notamment être un silicium amorphe hydrogéné, noté a-Si:H ; un silicium polycristallin ; un silicium monocristallin, noté c-Si ; ou encore un silicium nanocristallin, noté nc-Si.

En particulier, sont exclus de la couche interférentielle 15 tous les composés du silicium, dont notamment l'oxyde de silicium, le nitrure de silicium, l'oxynitrure de silicium, le carbure de silicium, et tous alliages de silicium avec d'autres éléments.

Dans la présente demande, on considère que la couche métallique réfléchissante 14 composée, en particulier constituée, de chrome, de cuivre, ou d'aluminium, et la couche interférentielle 15 composée, en particulier constituée, de silicium, peuvent en outre comporter des impuretés dans des proportions négligeables, notamment en fonction de la pureté des matériaux de base et/ou des procédés de dépôt desdites couches.

Par exemple, lesdites couches comprennent chacune les matériaux précités à au moins 99,9% et peuvent comporter jusqu'à 0,1% d'impuretés.

De manière préférentielle, la pièce de finition 10 peut également comprendre une couche de protection 16 déposée sur le revêtement décoratif 12.

Par exemple, la couche de protection 16 peut être un vernis comprenant une base choisie parmi le polyuréthane, l'époxy ou l'acrylate, et configuré pour être réticulée par un procédé thermique, par rayonnement ultraviolet (UV) ou par une combinaison des procédés précités.

Le vernis peut comprendre un agent matant.

Comme cela est décrit ci-après, la couche de protection 16 est transparente ou semi-transparente et n'altère pas la perception des couleurs interférentielles générées par le revêtement décoratif 12 du fait du choix des couches 14 et 15 et de la composition chimique de la couche de protection 16.

Dans l'exemple, illustré sur les figures 1 à 4, le revêtement décoratif 12 est appliqué sur le substrat 11 dans une configuration dite de « première surface », c'est-à-dire que le revêtement décoratif 12 est appliqué sur une face du substrat 11 qui est destiné à être orientée vers un utilisateur d'un dispositif muni de la pièce de finition.

Dans une telle configuration, la couche de base 13 le cas échéant, la couche métallique réfléchissante 14, la couche interférentielle 15 et la couche de protection 16 le cas échéant, sont successivement déposées sur le substrat 11, dans cet ordre.

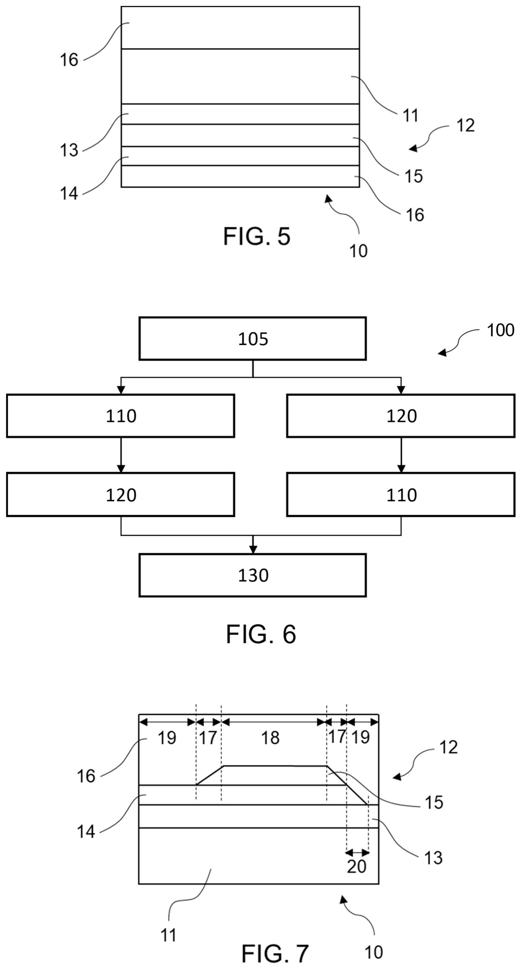

La figure 5 illustre la pièce de finition 10 dans une deuxième configuration, dite de « deuxième surface », c'est-à-dire que le revêtement décoratif 12 est appliqué sur une face du substrat 11 qui est destiné à être orientée en opposition à un utilisateur d'un dispositif muni de la pièce de finition.

Dans une telle configuration, la couche de base 13 le cas échéant, la couche interférentielle 15, la couche métallique réfléchissante 14 sont successivement déposées sur le substrat 11, dans cet ordre.

Dans une telle configuration, la couche de protection 16 peut être omise, le revêtement décoratif étant 12 située « derrière » le substrat 11 et protégé par ce dernier.

Une couche de protection 16 peut toutefois être appliquée sur une face du substrat 11 destinée à être orientée vers à un utilisateur d'un dispositif muni de la pièce de finition, pour protéger le substrat 11 lui-même.

La couche métallique réfléchissante 14 et la couche interférentielle 15 présentent chacune une épaisseur prédéterminée.

L'épaisseur de la couche métallique réfléchissante 14 et l'épaisseur de la couche interférentielle 15, et ainsi l'épaisseur totale du revêtement décoratif 12 qui en résulte, sont choisies de manière à conférer à la pièce de finition 10 une couleur interférentielle en réflexion prédéterminée ainsi qu'une transmission lumineuse prédéterminée.

Par « couleur interférentielle en réflexion », on entend le fait que la pièce de finition 10 présente un aspect coloré résultant d'une extinction partielle de longueurs d'onde prédéterminée de la lumière incidente sur celle-ci, conduisant à une réflexion de la lumière dans une bande de longueur d'ondes prédéterminée, produisant un aspect coloré d'une couleur prédéterminée.

Par exemple, les épaisseurs de la couche métallique réfléchissante 14 et de la couche interférentielle 15 sont choisies de sorte à conférer à la pièce de finition 10 :
- une couleur violette et/ou bleue lorsqu'elle est exposée à de la lumière blanche, c'est-à-dire que la lumière dans les longueurs d'ondes comprises environ entre 400 et 500 nanomètres est majoritairement réfléchie par le revêtement décoratif 12, et la lumière en dehors de la plage de longueurs d'ondes comprises environ entre 400 et 500 nanomètres est absorbée et/ou transmise (ainsi que réfléchie et détruite par interférence) par le revêtement décoratif 12 ; ou
- une couleur verte et/ou jaune lorsqu'elle est exposée à de la lumière blanche, c'est-à-dire que la lumière dans les longueurs d'ondes comprises environ entre 500 et 600 nanomètres est majoritairement réfléchie par le revêtement décoratif 12, et la lumière en dehors de la plage de longueurs d'ondes comprises environ entre 500 et 600 nanomètres est absorbée et/ou transmise (ainsi que réfléchie et détruite par interférence) par le revêtement décoratif 12 ; ou
- une couleur rose et/ou magenta lorsqu'elle est exposée à de la lumière blanche, c'est-à-dire que la lumière dans les longueurs d'ondes comprises environ entre 600 et 700 nanomètres est majoritairement réfléchie par le revêtement décoratif 12, et la lumière en dehors de la plage de longueurs d'ondes comprises environ entre 600 et 700 nanomètres est absorbée et/ou transmise (ainsi que réfléchie et détruite par interférence) par le revêtement décoratif 12.

Par exemple, les épaisseurs de la couche métallique réfléchissante 14 et de la couche interférentielle 15 sont en outre choisies de sorte à conférer à la pièce de finition 10 une transmission lumineuse comprise dans les plages de :
- 5% à 20%, préférentiellement dans les sous-plages de 5% à 10%, ou 10% à 15%, ou 15% à 20%, ou selon toute combinaison de ces sous-plages ;
- 10% à 30%, préférentiellement dans les sous-plages de 10% à 15%, ou 15% à 20%, ou 20% à 25%, ou 25% à 30%, ou selon toute combinaison de ces sous-plages ;
- 20% à 40%, préférentiellement dans les sous-plages de 20% à 25%, ou 25% à 30%, ou 30% à 35%, ou 35% à 40%, ou selon toute combinaison de ces sous-plages ;
- 30% à 50%, préférentiellement dans les sous-plages de 30% à 35%, ou 35% à 40%, ou 40% à 45%, ou 45% à 50%, ou selon toute combinaison de ces sous-plages ;
- 40 à 60%, préférentiellement dans les sous-plages de 40% à 45%, ou 45% à 50%, ou 50% à 55%, ou 55% à 60%, ou selon toute combinaison de ces sous-plages ; ainsi que dans toute combinaison des plages précitées.

Plus particulièrement, par exemple, les épaisseurs de la couche métallique réfléchissante 14 et de la couche interférentielle 15 sont choisies de sorte à conférer à la pièce de finition 10 une transmission lumineuse d'environ 5%, 10%, 15%, 20%, 25%, 30%, 35%, 40%, 45%, 50%, 55% ou 60%.

Par exemple, la couche métallique réfléchissante 14 présente une épaisseur comprise entre 10 et 40 nanomètres, préférentiellement entre 15 et 35 nanomètres, et encore plus préférentiellement de l'ordre de 25 nanomètres.

Par exemple, la couche interférentielle 15 présente une épaisseur comprise entre 20 et 100 nanomètres, préférentiellement comprise entre 25 et 80 nanomètres, et encore plus préférentiellement dans la sous-plage entre 25 et 35 nanomètres, entre 40 et 60 nanomètres, ou entre 65 et 80 nanomètres.

Le tableau 1 ci-après illustre, à titre non limitatif, la transmission lumineuse pour une longueur d'onde d'environ 600 nm et l'aspect coloré en réflexion qui est obtenu pour différentes configurations d'épaisseur de la couche métallique réfléchissante 14 et de la couche interférentielle 15.

**[Tab. 1]**

| Epaisseur couche métallique réfléchissante (nm) | Epaisseur couche interférentielle (nm) | TL à 600 nm (%) | Couleur en réflexion |
|---|---|---|---|
| 15 à 25 | 25 à 35 | 30 à 50 | Violet et/ou bleu |
| 15 à 25 | 40 à 60 | 20 à 40 | Vert et/ou jaune |
| 15 à 25 | 65 à 80 | 10 à 30 | Rose et/ou magenta |
| 25 à 35 | 25 à 35 | 20 à 40 | Violet et/ou bleu |
| 25 à 35 | 40 à 60 | 10 à 30 | Vert et/ou jaune |
| 25 à 35 | 65 à 80 | 5 à 20 | Rose et/ou magenta |

En particulier, dans le tableau 1 ci-dessous, la couche métallique réfléchissante est une couche de chrome.

La couche de base 13 et/ou la couche de protection 16 peuvent présenter une épaisseur comprise entre 10 et 30 micromètres, et préférentiellement entre 15 et 20 micromètres.

La couche métallique réfléchissante 14 et la couche interférentielle 15 sont ici des couches minces, qui peuvent être appliquées sur le substrat 11 selon toute méthode connue adaptée pour déposer de manière contrôlée une couche métallique, respectivement de silicium, sur une épaisseur sensiblement constante.

L'invention a ainsi pour objet un procédé 100 de fabrication d'une pièce de finition 10, illustré par le schéma bloc-diagramme de la figure 6, et comprenant les étapes décrites ci-dessous.

Le procédé 100 comprend une étape 110 de fourniture d'un substrat 11 transparent ou semi-transparent en matière plastique.

Le substrat 11 peut être réalisé par moulage pour lui donner la forme désirée.

Le procédé 100 comprend une étape 110 de dépôt de la couche métallique réfléchissante 14, composée de chrome, de cuivre ou d'aluminium, et préférentiellement composée de chrome.

Par exemple, l'étape 110 est une étape de dépôt physique en phase vapeur (dit PVD) de chrome, de cuivre ou d'aluminium, et préférentiellement de chrome.

De préférence, l'étape 110 est une étape de PVD par pulvérisation cathodique, en particulier de type magnétron, dans une chambre à vide.

L'étape 110 pourrait néanmoins également être une étape de PVD par évaporation thermique, ou tout autre étape de procédé adaptée.

Le procédé comprend une étape 120 de dépôt de la couche interférentielle 15, composée de silicium.

Par exemple, l'étape 120 est une étape de dépôt physique en phase vapeur (dit PVD) de silicium.

De préférence, l'étape 120 est une étape de PVD par pulvérisation cathodique, en particulier de type magnétron, dans une chambre à vide.

L'étape 120 pourrait néanmoins également être une étape de PVD par évaporation thermique, ou tout autre étape de procédé adaptée.

Le procédé 100 peut comprendre une étape 105 de dépôt d'une couche de base 13, sur le substrat 11, réalisée en amont des étapes 110 et 120.

Par exemple, la couche de base 13 est un vernis, par exemple comprenant une base choisie parmi le polyuréthane, l'époxy ou l'acrylate, et l'étape 105 comprend l'application du vernis sur le substrat 11, par exemple par peinture.

L'étape 105 peut comprendre la réticulation du vernis, par exemple par un procédé thermique, par rayonnement ultraviolet (UV) ou par une combinaison des techniques précitées.

En particulier, l'étape 120 de dépôt de la couche interférentielle 15 peut suivre l'étape 110 de dépôt de la couche métallique réfléchissante 14, pour obtenir une pièce de finition 10 telle que montrée sur les figures 1 à 4.

Ceci permet de réaliser un revêtement décoratif 12 dit en « première surface ».

En particulier, l'étape 120 de dépôt de la couche interférentielle 15 peut précéder l'étape 110 de dépôt de la couche métallique réfléchissante 14, pour obtenir une pièce de finition 10 telle que montrée sur la figure 5.

Ceci permet de réaliser un revêtement décoratif 12 dit en « deuxième surface ».

Le procédé 100 peut comprendre une étape 130 de dépôt d'une couche de protection 16 sur le revêtement décoratif 12 qu'il soit réalisé en première surface ou en deuxième surface, et/ou sur une surface du substrat 11 opposée à une surface sur laquelle est déposée le revêtement décoratif 12 lorsque celui-ci est déposé en deuxième surface.

Par exemple, la couche de protection 16 est un vernis, par exemple comprenant une base choisie parmi le polyuréthane, l'époxy ou l'acrylate, et l'étape 130 comprend l'application du vernis sur le revêtement décoratif 12, par exemple par peinture.

L'étape 130 peut comprendre la réticulation du vernis, par exemple par un procédé thermique, par rayonnement ultraviolet (UV) ou par une combinaison des techniques précitées.

Un tel procédé 100, en particulier mettant en œuvre des étapes de dépôt de couches par dépôt PVD, permet de contrôler de manière particulièrement précise l'épaisseur des couches déposées, et donc de contrôler de manière précise l'aspect coloré en réflexion obtenu ainsi que la transmission lumineuse obtenue.

Par un contrôle précis des paramètres du système de couches formant le revêtement décoratif 12, toute combinaison de couleurs et/ou de transmission lumineuses peut être obtenue, de manière particulièrement simple et commode.

Le système de couches métallique chrome, cuivre ou aluminium d'une part et silicium, d'autre part, et plus particulièrement le système chrome et silicium, permet d'obtenir une large palette de couleurs par le dépôt de couches relativement fines.

La couche interférentielle 15 composée de silicium permet l'obtention d'un revêtement décoratif 12 particulièrement translucide, tout en produisant des effets colorés interférentiels peu sensibles à l'application d'éventuelle(s) couche(s) de protection par-dessus le revêtement décoratif 12, c'est-à-dire que les effets colorés interférentiels ne sont pas ou peu éteints ou modifiés par de telle(s) couche(s) de protection.

La figure 7 illustre une variante de réalisation de la pièce de finition 10 illustrée aux figures 1 à 4, dans laquelle le revêtement décoratif 12 comprend au moins une première portion 17 présentant un gradient d'épaisseur entre une première zone 18 présentant ladite épaisseur prédéterminée de couche interférentielle 15 et une deuxième zone 19 dépourvue de couche interférentielle 15, autrement dit d'épaisseur nulle de la couche interférentielle 15.

La première portion 17 confère localement à la pièce de finition un dégradé de couleurs interférentielles en réflexion.

Le revêtement décoratif 12 peut également comprendre au moins une deuxième portion 20 présentant un gradient d'épaisseur entre une zone présentant ladite épaisseur prédéterminée de couche métallique réfléchissante 14 et une deuxième zone d'épaisseur nulle de la couche métallique réfléchissante 14.

La première portion 17 et la deuxième portion 20 peuvent être directement attenantes et continues, tel que cela est illustré sur la figure 7, c'est-à-dire qu'elles forment ensemble un gradient d'épaisseur du revêtement décoratif 12.

La première portion 17 et/ou la deuxième portion 20 peuvent chacun être obtenue par la mise en œuvre d'une étape de dépôt PVD configurée pour l'obtention d'un dégradé d'épaisseur de la couche interférentielle 15 et/ou de la couche métallique réfléchissante 14.

A cet effet, la pièce de finition 10 est traitée dans une chambre de dépôt de dépôt physique en phase vapeur, et l'étape de dépôt 120 et/ou l'étape de dépôt 110 comprend la configuration de la chambre de dépôt physique en phase vapeur avec la disposition d'un masque entre une cible de matériau de base à déposer en phase vapeur, ici une cible de Si pour la couche interférentielle et de Cr, Cu ou Al pour la couche métallique réfléchissante, et la pièce de finition 10.

Le masque, qui est choisi de sorte à être opaque à la pulvérisation de matériau de base à déposer, par exemple réalisé en matériau métallique tel que l'acier ou l'aluminium, est placé à distance de la pièce de finition 10, c'est-à-dire qu'il n'est pas en contact avec cette dernière.

Le masque comprend au moins un bord qui est placé en vis-à-vis de la pièce de finition 10, au niveau d'une zone de la pièce de finition 10 sur laquelle doit être formée la première portion 17 et/ou deuxième portion 20.

Lors de la pulvérisation du matériau de base à déposer, les zones du substrat 11 qui sont dans l'ombre du masque par rapport à la cible, c'est-à-dire une partie non-visible qui n'est pas dans la ligne de vue directe de la cible, ne sont pour pas recouvertes de la couche interférentielle 15 et/ou de la couche métallique réfléchissante 14, tandis que celles qui ne sont pas masquées par le masque, c'est-à-dire une partie visible qui est dans la ligne de vue directe de la cible, sont recouvertes de la couche interférentielle 15 et/ou de la couche métallique réfléchissante 14.

Au niveau de la zone du substrat 11 en vis-à-vis du bord du masque, l'épaisseur de la couche interférentielle 15 et/ou de la couche métallique réfléchissante 14 ne passe pas abruptement d'une épaisseur à une autre (ou à une épaisseur nulle), mais de façon progressive.

Ceci est dû au fait qu'une certaine quantité de matériau à déposer parvient aux zones du substrat 11 qui sont « derrière » le masque par rapport à la cible, mais qui sont dans la ligne de vue directe d'une partie de la cible.

Ceci est rendu possible en raison de la distance du masque par rapport au substrat 11.

Ainsi, la première portion 17 et/ou la deuxième portion 20 peut être formée sur la pièce de finition 10 en vis-à-vis d bord du masque de manière particulièrement commode, tout en étant particulièrement contrôlable.

En effet, la disposition du masque peut se faire à une distance prédéterminée de la pièce de finition, cette distance prédéterminée déterminant la dimension de la première portion 17 et/ou la deuxième portion 20 dans au moins une direction de dégradé, qui s'étend entre la partie visible et la partie non-visible.

Ainsi, en rapprochant le masque du substrat 11, la dimension de la première portion 17 et/ou la deuxième portion 20 est réduite (moins de matière pulvérisée étant susceptible de parvenir « derrière » le masque), et en éloignant le masque du substrat 11, la dimension de la première portion 17 et/ou la deuxième portion 20 est augmentée (davantage de matière pulvérisée étant susceptible de parvenir « derrière » le masque).

Selon un autre mode de réalisation de l'étape 120 de dépôt et/ou de l'étape 110 de dépôt, la chambre est configurée avec la pièce de finition 10 qui est disposée de sorte qu'une partie visible par la cible soit orientée vers la cible et une partie non-visible par la cible soit orientée en éloignement de la cible.

La partie de la pièce de finition 10 orientée vers la cible (c'est-à-dire dont la normale à la surface est dirigée comprend une composante dirigée vers la cible) est visible de la cible et reçoit du matériau de base à déposer.

La partie de la pièce de finition 10 orientée en éloignement de la cible (c'est-à-dire dont la normale à la surface est dirigée comprend une composante en éloignement de la cible) n'est pas visible de la cible et ne reçoit pas de matériau de base à déposer.

La première portion 17 et/ou la deuxième portion 20 est formée à la frontière entre les parties visibles et non-visible.

Dans ce mode de réalisation également, la dimension des première portion 17 et/ou deuxième portion 20 peut être contrôlée, toutefois ici en ajustant directement la distance séparant la pièce de finition 10 et la cible, et/ou l'orientation par rapport à cette dernière.

A cet effet, la pièce de finition 10 est disposée à une distance prédéterminée de la cible et/ou avec une orientation prédéterminée par rapport à la cible, cette distance et/ou orientation déterminant la dimension la première portion 17 et/ou la deuxième portion 20 dans au moins une direction de dégradé entre la partie visible et la partie non-visible.

Plus la pièce de finition 10 est éloignée de la cible, plus la dimension de la première portion 17 et/ou la deuxième portion 20 selon la direction de dégradé est importante, et inversement.

Plus généralement, la pièce de finition décrite ci-avant peut être :
- une pièce aéronautique, nautique, ou de tout autre véhicule. Il peut en particulier s'agir d'une pièce de décor, par exemple intérieure, d'un avion, d'un bateau ou de tout autre véhicule ;
- une pièce d'un appareil électroménager (lave-linge, four, sèche-cheveux, lisseur à cheveux, etc.), de cuisine (robot pâtissier, mixeur, etc.), électronique (modem, décodeur de télévision, console de jeux, ordinateur, téléphone mobile, etc.) ;
- une pièce de type contenant, par exemple cosmétique (flacon, pot, boîtier pour maquillage, etc.), ou encore alimentaire (bouteille, boîte, etc.).

Plus généralement, le procédé peut être mis en œuvre sur tout substrat de pièce en matière plastique.

On rappelle que l'invention ne se limite pas aux exemples décrits et illustrés.

## Revendications

1. Pièce de finition (10), **caractérisée en ce qu'**elle comprend un substrat (11) transparent ou semi-transparent en matière plastique et un revêtement décoratif (12) semi-transparent appliqué sur tout ou partie du substrat (11), le revêtement décoratif (12) semi-transparent comprenant une couche métallique réfléchissante (14) semi-transparente composée de chrome (Cr), de cuivre (Cu) ou d'aluminium (AI), ainsi qu'une couche interférentielle (15) transparente ou semi-transparente composée de silicium (Si) élémentaire, superposée sur la couche métallique réfléchissante (14), chacune de la couche métallique réfléchissante (14) et la couche interférentielle (15) présentant une épaisseur prédéterminée, pour conférer ensemble à la pièce de finition (10) une couleur interférentielle en réflexion prédéterminée ainsi qu'une transmission lumineuse prédéterminée.

2. Pièce de finition (10) selon la revendication 1, dans laquelle la couche métallique réfléchissante (14) semi-transparente est composée de chrome.

3. Pièce de finition (10) selon la revendication 1 ou 2, dans laquelle la couche métallique réfléchissante (14) et la couche interférentielle (15) présentent une épaisseur prédéterminée pour conférer à la pièce de finition (10) une transmission lumineuse pour les longueurs d'ondes d'environ 600 nanomètres qui est inférieure ou égale à 60 %, et préférentiellement supérieure ou égale à 5 %.

4. Pièce de finition (10) selon l'une quelconque des revendications 1 à 3, dans laquelle la couche métallique réfléchissante (14) présente une épaisseur comprise entre 10 et 40 nanomètres, préférentiellement entre 15 et 35 nanomètres, et encore plus préférentiellement de l'ordre de 25 nanomètres.

5. Pièce de finition (10) selon l'une quelconque des revendications 1 à 4, dans laquelle la couche interférentielle (15) présente une épaisseur comprise entre 20 et 100 nanomètres

6. Pièce de finition (10) selon l'une quelconque des revendications 1 à 5, dans laquelle la couche métallique réfléchissante (14) est déposée sur le substrat (11), et la couche interférentielle (15) est déposée sur la couche métallique (14).

7. Pièce de finition (10) selon l'une quelconque des revendications 1 à 6, comprenant en outre une couche de protection (16) transparente ou semi-transparente, déposée sur le revêtement décoratif (12).

8. Pièce de finition (10) selon la revendication 7, dans laquelle la couche de protection (16) est un vernis comprenant une base choisie parmi le polyuréthane, l'époxy ou l'acrylate, et configurée pour être réticulée par un procédé thermique, par rayonnement ultraviolet (UV) ou par une combinaison des procédés précités, le vernis pouvant comprendre un agent matant.

9. Pièce de finition (10) selon la revendication 7 ou 8, dans laquelle la couche de protection (16) présente une épaisseur comprise entre 10 et 30 micromètres, et préférentiellement entre 15 et 20 micromètres.

10. Pièce de finition (10) selon l'une quelconque des revendications 1 à 9, dans laquelle la couche interférentielle (15) comprend au moins une portion (17) présentant un gradient d'épaisseur entre une zone (18) de la couche interférentielle (15) présentant ladite épaisseur prédéterminée et une zone (19) dépourvue de couche interférentielle (15) et possiblement de couche métallique réfléchissante (14), ladite au moins une portion (17) conférant localement à la pièce de finition (10) un dégradé de couleurs interférentielles en réflexion.

11. Pièce de finition (10) selon l'une quelconque des revendications 1 à 10, dans laquelle le substrat (11) est en polycarbonate (PC) ou en polyméthacrylate de méthyle (PMMA), préférentiellement chargé en agents ou par des mélanges maître conférant des propriétés opalescentes, et/ou nacrantes, et/ou colorantes, et/ou de protection notamment UV et/ou thermique et/ou mécanique.

12. Pièce de finition (10) selon l'une quelconque des revendications 1 à 11, comprenant une couche de base (13) transparente ou semi-transparente, déposée sur le substrat (11), et le revêtement décoratif (12) étant déposé sur la couche de base (13).

13. Pièce de finition (10) selon la revendication 12, dans laquelle la couche de base (13) est un vernis comprenant une base choisie parmi le polyuréthane, l'époxy ou l'acrylate, et configurée pour être réticulée par un procédé thermique, par rayonnement ultraviolet (UV) ou par une combinaison des procédés précités, le vernis pouvant comprendre un agent matant.

14. Dispositif comprenant une pièce de finition (10) selon l'une quelconque des revendications 1 à 13, le dispositif étant un véhicule, de préférence automobile, un appareil électroménager, ou un contenant, de préférence cosmétique ou alimentaire.

15. Procédé de fabrication d'une pièce de finition (10) selon l'une quelconque des revendications 1 à 13, comprenant les étapes de :
- fourniture d'un substrat (11) transparent ou semi-transparent en matière plastique ;
- dépôt de la couche métallique réfléchissante (14) semi-transparente ;
- dépôt de la couche interférentielle (15) semi-transparente.

16. Procédé selon la revendication 15, dans lequel les étapes de dépôt de la couche métallique réfléchissante et/ou de dépôt de la couche interférentielle sont réalisées par dépôt physique en phase vapeur (PVD).

17. Procédé selon l'une des revendications 15 et 16, dans lequel l'étape de dépôt de la couche interférentielle semi-transparente est réalisée à la suite de l'étape de dépôt de la couche métallique réfléchissante semi-transparente, et le procédé comprend en outre une étape de dépôt d'une couche de protection (16) transparente ou semi-transparente, qui est préférentiellement une étape de peinture d'un vernis, réalisée à la suite de l'étape de dépôt de la couche interférentielle semi-transparente.

18. Procédé selon l'une des revendications 15 et 16, dans lequel l'étape de dépôt de la couche métallique réfléchissante semi-transparente est réalisée à la suite de l'étape de dépôt de la couche interférentielle semi-transparente, et le procédé comprend optionnellement une étape de dépôt d'une couche de protection (16) transparente ou semi-transparente, qui est préférentiellement une étape de peinture d'un vernis, réalisée à la suite de l'étape de dépôt de la couche métallique réfléchissante semi-transparente.

19. Procédé selon l'une quelconque des revendications 15 à 18, comprenant en outre une étape de dépôt d'une couche de base (13) transparente ou semi-transparente sur le substrat (11), qui est préférentiellement une étape de peinture d'un vernis, réalisée avant l'étape de dépôt de la couche interférentielle semi-transparente et l'étape de dépôt de la couche métallique réfléchissante semi-transparente.
